# EUROPÄISCHE PATENTSCHRIFT

(11) **EP 1 116 181 B1**
(45) Veröffentlichungstag und Bekanntmachung des Hinweises auf die Patenterteilung: **13.11.2002**
(21) Anmeldenummer: 99947274.9
(22) Anmeldetag: 02.09.1999
(51) Int. Cl.: G06K 19/077

(54) **TRANSPONDERMODUL UND VERFAHREN ZUR HERSTELLUNG DESSELBEN**
TRANSPONDER MODULE AND A METHOD FOR PRODUCING THE SAME
MODULE TRANSPONDEUR ET PROCEDE PERMETTANT DE LE PRODUIRE

(30) Priorität: 03.09.1998 DE 19840220
(43) Veröffentlichungstag der Anmeldung: 18.07.2001
(73) Patentinhaber: Fraunhofer-Gesellschaft zur Förderung der angewandten Forschung e.V., 80636 München (DE)
(72) Erfinder: PLETTNER, Andreas, D-82340 Feldafing (DE); HABERGER, Karl, D-82152 Planegg (DE)
(74) Vertreter: Schoppe, Fritz, Dipl.-Ing.
(86) Internationale Anmeldenummer: EP9906467
(87) Internationale Veröffentlichungsnummer: WO00014680

(56) Entgegenhaltungen:
- EP-A- 0 615 285
- DE-A- 19 613 635
- FR-A- 2 760 113
- PATENT ABSTRACTS OF JAPAN vol. 018, no. 629 (E-1637), 30. November 1994 (1994-11-30) & JP 06 244539 A (TOSHIBA CORP), 2. September 1994 (1994-09-02)

## Beschreibung

Durch die Entwicklung kontaktbehafteter und kontaktloser Chipkarten hat sich ein völlig neuer und schnell wachsender Markt für elektronische Mikro-Systeme ergeben. Integrierte Schaltungen werden nunmehr nicht mehr lediglich in Großgeräte oder auch Handsysteme eingebaut, sondern sozusagen "nackt" in Chipkarten. Eine konsequente Weiterentwicklung führt zur sogenannten "Wegwerfelektronik", deren erster Vertreter die Telefonkarte war. Neuere Anwendungsgebiete für diese sogenannte "Wegwerfelektronik" sind elektronische Etiketten, die preisgünstige Chips bzw. Mikromodule in preisgünstigen ökologisch akzeptierten Trägern erfordern. Den einfachsten Fall eines elektronischen Etiketts würde die Einbettung eines kontaktlosen Moduls, das aus einer integrierten Schaltung und einer Antennenspule besteht, zwischen zwei Papieren darstellen.

Transpondermodule für elektronische Etiketten sind aus den Patent Abstracts of Japan, Veröffentlichungsnummer 09297535A zu der japanischen Anmeldung 08109052 und den Patent Abstracts of Japan, Veröffentlichungsnummer 09293130A zu der japanischen Anmeldung 08109051 offenbart. Bei den in den oben genannten Schriften beschriebenen elektronischen Etiketten ist ein integrierter Schaltungschip zusammen mit einer Antenne in ein filmartiges Harz eingegossen. Dieses filmartige Harz wird dann in eine Metallform eingebracht, in der ein äußeres Harz um das filmartige Harz herumgegossen wird.

Die Patent Abstracts of Japan, Veröffentlichungsnummer 090198481A zu der japanischen Anmeldung 08005845 offenbaren ein elektronisches Etikett, bei dem ein Schaltungschip und eine Antenne vom Schleifentyp auf ein Substrat aufgebracht sind, wobei das äußere Ende der Antenne über eine Überbrückungsmetallisierung, die über die Windungen der Antenne geführt ist und von denselben mittels einer isolierenden Harzschicht getrennt ist, mit einem Anschluß auf der integrierten Schaltung verbunden ist.

In den Patent Abstracts of Japan, Veröffentlichungsnummer 08216573A zu der japanischen Anmeldung 07021785 ist eine kontaktfreie IC-Karte beschrieben, die einen Schaltungschip und einen Antennenabschnitt aufweist. Der Schaltungschip ist auf einem Schaltungsabschnitt, der auf einem Polyesterfilm vorgesehen ist, angebracht, wobei auch der Antennenabschnitt auf dem Polyesterfilm gebildet ist. Mittels einer Haftschicht ist ein zweiter Polyesterfilm, der den Schaltungschip einbettet, auf dem ersten Polyesterfilm gebildet. Darüberhinaus ist ein dritter Polyesterfilm mittels einer weiteren Haftschicht auf der Oberfläche des zweiten Polyesterfilms angebracht.

In der DE 19639902 A1 sind kontaktlose Chipkarten und Verfahren zur Herstellung derselben beschrieben. Die dort beschriebenen Chipkarten weisen einen elektrisch isolierenden, einstückigen Kartenkörper auf, der eine oder mehrere Aussparungen auf einer Seite desselben besitzt. Ferner ist ein Leiterbahnmuster auf der Oberfläche des Kartenkörpers vorgesehen, wobei die Leiterbahnen direkt auf Oberflächenbereichen der mit wenigstens einer Aussparung versehenen Kartenkörperseite angebracht sind, wobei in den Aussparungen ein oder mehrere Chips, die mit wenigstens einer der Leiterbahnen kontaktiert sind, angeordnet sind.

Eine Übersicht bekannter Verfahren zum Aufbringen von integrierten Schaltungschips auf einem Substrat, beispielsweise durch ein Flip-Chip-Verfahren, ist bei H. Reichl u.a.: Packaging-Trends: High-Tech im Kleinstformat, Elektronik 12/1998 (oder SMT Nürnberg 98, Conference Proceedings), zu finden.

Die FR 2760113 A bezieht sich auf ein Verfahren zum Herstellen einer Chipkarte zur kontaktlosen Signalübertragung, bei dem zunächst ein Modul aus einer integrierten Schaltung und einer Flachspulenantenne hergestellt wird, indem die Enden der Flachspulenantenne an Anschlußflächen der integrierten Schaltung gelötet werden. Dann wird der integrierte Schaltungschip derart in eine Öffnung eines Kunststoffträgers eingebracht, daß die Flachspule auf der Oberfläche des Kunststoffträgers zu liegen kommt und der Schaltungschip an einem Haftmittelfilm, der die Unterseite der Öffnung des Kunststoffträgers verschließt, haftet. Eine weitere Kunststoffplatte wird mittels einer Verbindungsschicht mit dem Kunststoffträger verbunden, derart, daß die Antenne und die integrierte Schaltung eingekapselt sind. Abschließend kann die Haftmittelschicht entfernt werden.

Die Aufgabe der vorliegenden Erfindung besteht darin, Verfahren zur Herstellung eines ultraflachen Transpondermoduls zu schaffen.

Diese Aufgabe wird durch Verfahren gemäß den Ansprüchen 1, 2, 3 und 5 gelöst.

Der vorliegenden Erfindung liegt ferner die Aufgabe zugrunde, ein preisgünstig mittels Technologien der Massenfertigung herstellbares, ultraflaches Transpondermodul, insbesondere für ein elektronisches Etikett, zu schaffen.

Diese Aufgabe wird durch ein Transpondermodul gemäß Anspruch 8 gelöst.

Die vorliegende Erfindung schafft Verfahren zur Herstellung eines Transpondermoduls, die mit einem sehr geringen zeitlichen und materiellen Aufwand durchführbar sind. Insbesondere liefern dieselbe eine einfache Aufbau- und Verbindungs-Technik, die sich an den Erfordernissen einer preisgünstigen Massenfertigung orientiert.

Das erfindungsgemäße Transpondermodul ist als "Wegwerfelektronik" geeignet, da dasselbe aus einem preisgünstigen Schaltungschip und einem preisgünstigen ökologisch akzeptierten Träger, der durch das Isolationssubstrat gebildet ist, besteht. Das erfindungsgemäße kontaktlose Transpondermodul, das bei einem bevorzugten Ausführungsbeispiel aus einem Schaltungschip und einer Antennenspule, die von einem einzigen isolierenden Substrat gehalten sind, besteht, kann zwischen zwei Papiere bzw. andere dünne, flexible Substrate, wie z.B. Polymerfolien, eingebettet werden. Das erfindungsgemäße Transpondermodul kann sich dabei durch eine extrem geringe Gesamthöhe auszeichnen. Dadurch ist der Einbau in oder zwischen dünne Substrate möglich, wobei durch den geringen Dickenauftrag des erfindungsgemäßen Transpondermoduls nachfolgende papiertechnische Vorgänge, wie z.B. Bedrucken, Laminieren, usw., nicht beeinträchtigt werden. Darüberhinaus ist das erfindungsgemäße Transpondermodul sehr massearm, was sich positiv auf die Materialkosten und die Entsorgung der "Wegwerfelektronik" auswirkt.

Der Schaltungschip des erfindungsgemäßen Transpondermoduls kommt üblicherweise mit zwei elektrischen Anschlüssen aus, die sowohl eine Energieversorgung als auch einen bidirektionalen Datenfluß sicherstellen. Mittels dieser beiden Anschlüsse des Schaltungschips können alle Funktionen eines intelligenten Etiketts, beispielsweise für berührungslos abfragbare Identifikationssysteme aller Art von einfacher Güterkennzeichnung bis hin zu Tickets, realisiert werden.

Ein wichtiger Aspekt bei einem solchen Transpondermodul ist die Verbindungstechnik des Schaltungschips mit der Antenneneinrichtung. Da gemäß der vorliegenden Erfindung zumindest eine Hauptoberfläche des Schaltungschip mit einer Hauptoberfläche des einzigen vorgesehenen Trägersubstrats bündig ist, kann eine solche Verbindung einfach und mit einem geringen Dickenauftrag durchgeführt werden. Somit ermöglicht die vorliegende Erfindung ein Transpondermodul mit geringer Größe und geringem Gewicht, das zum einen kostengünstig ist und zum anderen eine hohe Leistungsfähigkeit und Zuverlässigkeit aufweist.

Da das erfindungsgemäße Transpondermodul eine sehr geringe Dicke aufweist, sind übliche Verfahren zum Bilden einer Lichtschutzschicht, beispielsweise das Aufbringen eines Epoxytropfens, der Rußpartikel aufweist, nicht einsetzbar, da die Dicke dieses Tropfens die Dicke des Schaltungschips bei weitem übertrifft. Ein Lichtschutz kann bei dem erfindungsgemäßen Transponderchip dadurch realisiert sein, daß die metallischen Anschlußflächen des Schaltungschips auf der oder den Hauptoberflächen desselben derart ausgebildet sind, daß sie zumindest über allen aktiven Bereichen des Schaltungschips angeordnet sind und somit einen Lichteinfall auf diese aktiven Bereiche verhindern. Somit ist eine Beeinträchtigung der Funktionsweise des Schaltungschips durch eine Ladungsträgergeneration, die durch einen Lichteinfall bewirkt wird, ausgeschlossen. Alternativ kann diese Lichtschutzschicht aus einem Halbleitermaterial, das einen geringeren Bandabstand als Silizium aufweist, oder ein hochleitfähiges Silizid gebildet sein, wobei auch eine solche Lichtschutzschicht bei einer sehr geringen Dicke ein ausgezeichnetes Lichtabsorptionsvermögen besitzt.

Soll das erfindungsgemäße Transpondermodul für elektronische Etiketten in besonders rauhen Umgebungen eingesetzt werden, in denen beispielsweise eine hohe Feuchtigkeit vorliegt, ist es möglich, auf der ersten und/oder zweiten Hauptoberfläche des isolierenden Trägersubstrats eine Passivierungsschicht einer Dicke von weniger als 5 µm, vorzugsweise einer Dicke von 1 µm, vorzusehen. Eine derart dünne Passivierungsschicht erhöht die Gesamtdicke des Transpondermoduls lediglich in einer Weise, die nach dem Einbringen des Transpondermoduls zwischen zwei Papierschichten oder dergleichen, die Bearbeitbarkeit, beispielsweise die Bedruckbarkeit, des so entstandenen elektronischen Etiketts nicht beeinträchtigt.

Die vorliegende Erfindung bezieht sich ferner auf Verfahren, um ein extrem dünnes Transpondermodul durch geeignete Verbindungstechniken, durch eine geeignete Anordnung der Anschlüsse auf dem Schaltungschip und durch eine geeignete Anordnung des Schaltungschips in einem Trägersubstrat herzustellen. Zur Kontaktierung des Schaltungschips, bzw. zum Anbringen desselben an dem Trägersubstrat, können eine Vielzahl bekannter Verfahren verwendet werden, beispielsweise ein Flip-Chip-Bonden oder ein Kleben des Schaltungschips an das Substrat mittels eines leitfähigen Klebers oder mittels eines anisotrop leitfähigen Klebers. Ferner kann eine Kontaktierung und ein gleichzeitiges Erzeugen einer peripheren Leiterstruktur mittels eines Siebdruckverfahrens durchgeführt werden.

Weiterbildungen der vorliegenden Erfindung sind in den abhängigen Ansprüchen dargelegt.

Bevorzugte Ausführungsbeispiele der vorliegenden Erfindung werden nachfolgend bezugnehmend auf die beiliegenden Zeichnungen näher erläutert. Es zeigen:
- Fig. 1: eine schematische Querschnittansicht eines erfindungsgemäßen Transpondermoduls;
- Fig. 2: eine Draufsicht des in Fig. 1 dargestellten Transpondermoduls;
- Fig. 3a) bis 3c): schematische Querschnittdarstellungen zur Veranschaulichung, wie bei dem erfindungsgemäßen, Transpondermodul ein Lichtschutz des Schaltungschips erreicht wird;
- Fig. 4: eine schematische Querschnittdarstellung eines alternativen Ausführungsbeispiels zur Realisierung eines Lichtschutzes;
- Fig. 5a) bis 5b): schematische Querschnittansichten zur Veranschaulichung eines ersten Ausführungsbeispiels des erfindungsgemäßen Verfahren;
- Fig. 6a) bis 6f): schematische Querschnittansichten zur Veranschaulichung eines zweiten Ausführungsbeispiels des erfindungsgemäßen Verfahren;
- Fig. 7a) bis 7g): schematische Querschnittansichten zur Veranschaulichung eines dritten Ausführungsbeispiels des erfindungsgemäßen Verfahren;
- Fig. 8a) bis 8e): schematische Querschnittansichten zur Veranschaulichung eines vierten Ausführungsbeispiels des erfindungsgemäßen Verfahren;

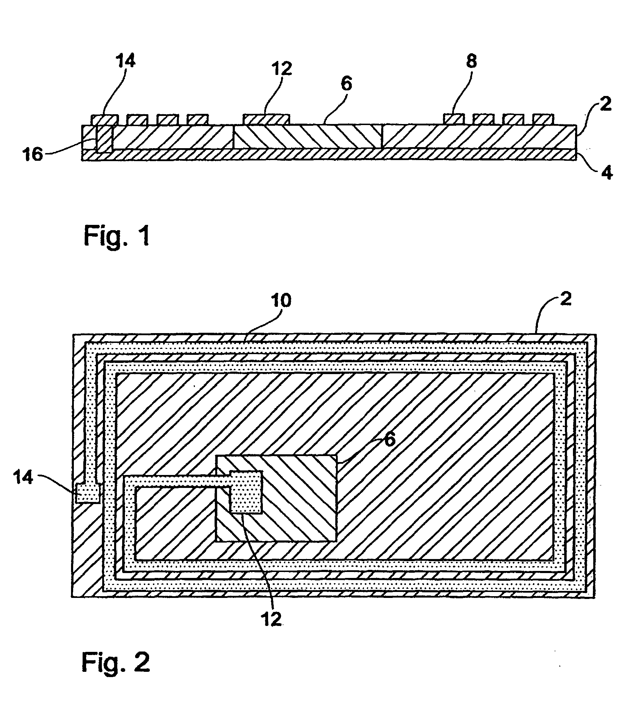

In Fig. 1 ist ein Ausführungsbeispiel eines Transpondermoduls gemäß der vorliegenden Erfindung dargestellt. Das Transpondermodul besitzt ein isolierendes Substrat 2, das aus einem beliebigen isolierenden Material bestehen kann, auf. Das Isolationssubstrat 2 kann beispielsweise ein flexibles Substrat aus einer Polymerfolie sein, bzw. aus Papier oder Kunststoff bestehen. Auf die Rückseite des Substrats 2 ist vorzugsweise ganzflächig eine Metallisierung 4 aufgebracht. In einer Ausnehmung des Isolationssubstrats 2 ist passend ein Schaltungschip 6 angeordnet, derart, daß eine Anschlußfläche (nicht gezeigt) auf der unteren Hauptoberfläche des Schaltungschips in Kontakt mit der Metallisierungsschicht 4 ist. Auf der oberen Hauptoberfläche des Isolationssubstrats 2 ist eine strukturierte Metallisierung 8 vorgesehen, die, wie in Fig. 2 dargestellt ist, eine Spule 10 mit einer Mehrzahl von Wicklungen definiert. Die strukturierte Metallisierung 8 ist ferner derart ausgebildet, daß ein erstes Anschlußende 12 derselben mit einer in der oberen Hauptoberfläche des Schaltungschip 6 angeordneten Anschlußfläche (nicht gezeigt) elektrisch leitfähig verbunden ist. Ein zweites Anschlußende 14 der strukturierten Metallisierung 8, das das äußere Anschlußende der Spule 10 ist, ist über eine Durchkontaktierung 16, die das Isolationssubstrat 2 durchdringt, mit der Metallisierungsschicht 4, die auf der unteren Oberfläche des Isolationssubstrat 2 vorgesehen ist, verbunden.

Das in Fig. 1 dargestellte Ausführungsbeispiel eines Transpondermoduls besitzt vorzugsweise eine Gesamthöhe von weniger als 25 µm, wobei die jeweiligen Metallisierungsebenen 4 und 8 eine Höhe von ca. 5 µm aufweisen können, während das Isolationssubstrat 2 und der Schaltungschip 6 beispielsweise eine Höhe von ca. 15 µm aufweisen können. Diese geringe Höhe des Transpondermoduls kann durch die einfache Verbindung von jeweils in einer Hauptoberfläche des Schaltungschips gebildeten Anschlußflächen mit der Metallisierungsschicht 4 bzw. dem Anschlußende 12 der strukturierten Metallisierung 8 erreicht werden. Diese einfache Verbindungstechnik ist möglich, da beide Hauptoberflächen des Schaltungschip 6 bündig mit den Hauptoberflächen des Isolationssubstrats 2 sind, so daß jeweils eine direkte Verbindung der Metallisierungsebenen 4 und 8 mit den in den Hauptoberflächen des Schaltungschips 6 gebildeten Anschlußflächen realisiert werden kann.

Die bei dem in den Fig. 1 und 2 gezeigten Ausführungsbeispiel auf die Oberfläche des Isolationssubstrats aufgebrachte strukturierte Metallisierung kann beispielsweise mittels bekannter Dünnfilmtechniken, Siebdrucktechniken oder Stempeltechniken aufgebracht werden. Alternativ kann auch ein feiner Draht verwendet werden, der auf dem Substrat verlegt wird. Alternativ kann der Draht mittels Thermokompressionstechniken teilweise in das Substrat versenkt werden. Dieser Draht sollte möglichst leitfähig und gleichzeitig dünn sein, wobei jedoch darauf zu achten ist, daß der Draht eine ausreichende Querschnittfläche aufweist, damit die Güte des Transponderschwingkreises nicht zu klein wird. Beispielsweise kann ein Draht mit einem Durchmesser im Bereich von 30 µm verwendet werden. Dabei ist es bevorzugt, daß der Draht einen rechteckigen oder elliptischen Querschnitt aufweist, um die Güte zu steigern ohne die Dicke zu erhöhen. Der Draht kann ferner mit einem dünnen Kunststoffmaterial isoliert sein, wobei das Abisolieren des Kunststoffmantels an den Kontakten durch die lokale Zufuhr von Wärme erreicht werden kann.

Auf beiden Hauptoberflächen des Transpondermoduls kann jeweils eine sehr dünne Passivierungsschicht einer Dicke von weniger als 5 µm vorzugsweise einer Dicke von 1 µm, aufgebracht sein, um Feuchtigkeit abzuhalten und eine Kontamination sowie Oberflächenleckströme zu verhindern. Als derartige Passivierung sind insbesondere Polymerschichten, beispielsweise Polyimid, sowie anorganische Schichten, wie Nitride, Oxide usw., geeignet.

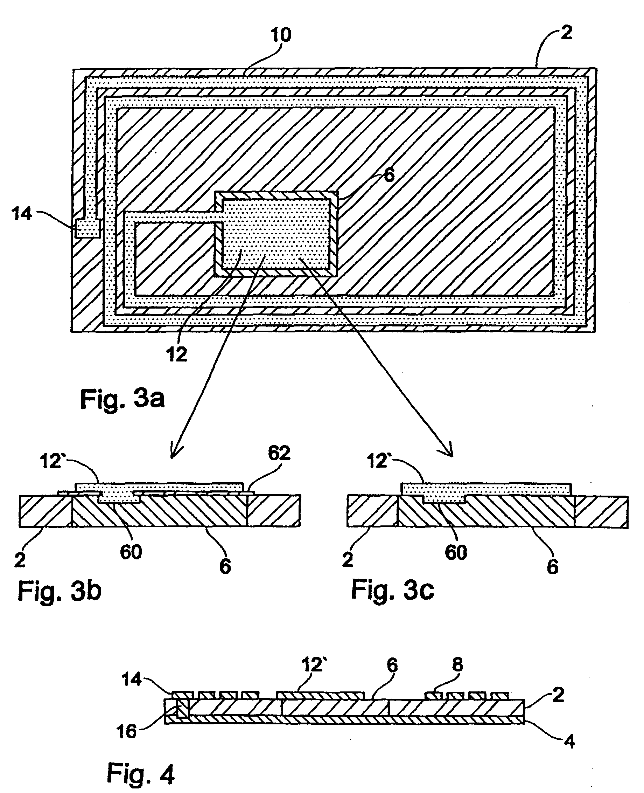

In den Fig. 3a) bis 3c) und in Fig. 4 sind Ausführungsbeispiele dargestellt, wie bei dem erfindungsgemäßen Transpondermodul ein Lichtschutz der aktiven Bereiche des Schaltungschips realisierbar ist. Hierbei sind in diesen Fig. für Elemente, die gleich denen in Fig. 1 sind, gleiche Bezugszeichen verwendet, wobei diese Elemente nicht erneut beschrieben werden.

In 3a) ist eine Draufsicht auf ein Transpondermodul gezeigt, wobei zu sehen ist, daß im Vergleich zu Fig. 2 das zweite Anschlußende 12' der Spule 10 derart vergrößert ist, daß dasselbe die obere Oberfläche des Schaltungschips 6 im wesentlichen bedeckt. Durch diese Metallisierung, die beispielsweise eine Dicke von 1 µm aufweise kann, kann ein zuverlässiger Lichtschutz erreicht werden. In Fig. 3b) ist gezeigt, wie die Metallisierung 12' des zweiten Anschlußendes mit einer in der oberen Hauptoberfläche des Schaltungschips 6 vorgesehenen Anschlußfläche 60 verbunden ist, wobei zwischen der Metallisierung 12' und dem Schaltungschip 6 eine Isolationsschicht 62 vorgesehen ist, um eine Isolation der Metallisierung von dem Halbleitermaterial des Schaltungschips 6 zu bewirken. Ist eine solche Isolation nicht erforderlich, kann, wie in Fig. 3c) gezeigt ist, die Isolationsschicht 62 weggelassen sein. In Fig. 4 ist nochmals eine schematische Querschnittdarstellung gezeigt, die veranschaulicht, wie bei dem in Fig. 1 dargestellten Ausführungsbeispiel durch eine Vergrößerung des Anschlußendes 12, um die dargestellte Form 12' zu besitzen, ein Lichtschutz für den Schaltungschip 6 erreicht werden kann. Hierbei ist durch die auf der Rückseite vorgesehene Metallisierung 4 auch ein Lichtschutz von der Rückseite her gewährleistet.

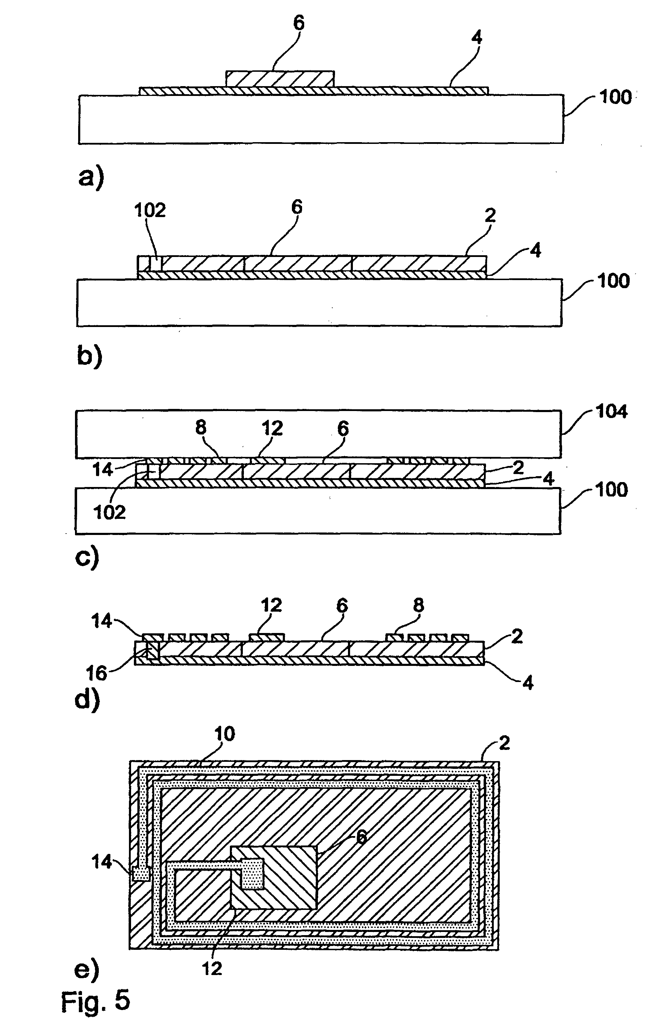

Bevorzugte Ausführungsbeispiele zur Herstellung des erfindungsgemäßen Transpondermoduls werden nachfolgend bezugnehmend auf die Fig. 5 bis 8 näher erläutert.

Ein Verfahren zur Herstellung des in Fig. 1 gezeigten Ausführungsbeispiels des erfindungsgemäßen Transpondermoduls ist in den Fig. 5a) bis 5e) gezeigt. Wie Fig. 5a) gezeigt ist, wird zunächst ein erster Hilfsträger 100 bereitgestellt, auf den eine Metallisierungsschicht 4 aufgebracht wird, die bei bevorzugten Ausführungsbeispielen des erfindungsgemäßen Verfahrens eine Fläche, die der Größe des herzustellenden Transpondermoduls entspricht, vollständig besetzt. Jedoch kann die Metallisierungsschicht 4 auch eine strukturierte Metallisierung sein. Auf diese Metallisierungsschicht wird ein Schaltungschip 6, der auf der Unterseite desselben eine Anschlußfläche (nicht gezeigt) aufweist, aufgebracht und im gleichen Verarbeitungsschritt elektrisch verbunden. Der Hilfsträger 100 dient zur Stabilisierung, da die Metallisierungsschicht 4 lediglich eine sehr geringe Dicke im Bereich von ca. 5 µm oder darunter aufweist.

Nach dem Aufbringen des Schaltungschips 6 wird um denselben eine Isolationsschicht 2 gebildet, die direkt an die Umrisse des Schaltungschips 6 angrenzt und deren Hauptoberfläche bündig mit der freiliegenden Hauptoberfläche des Schaltungschips 6 ist. Folglich ist der Schaltungschip 6 passend in einer Ausnehmung des Isolationssubstrats 2 angeordnet. Ferner wird in dem Isolationssubstrat 2 eine Öffnung 102 gebildet, die für eine spätere Durchkontaktierung dient. Diese Öffnung kann mittels bekannter Verfahren, beispielsweise photolithographisch erzeugt werden. Die sich ergebende Struktur ist in Fig. 5b) gezeigt.

In einem folgenden Schritt wird eine strukturierte Metallisierung auf die freiliegende Oberfläche des Isolationssubstrats 2 sowie des Schaltungschips 6 aufgebracht. Wie in Fig. 5c) gezeigt ist, wird diese strukturierte Metallisierung 8 vorzugsweise mittels eines zweiten Hilfsträgers 104 aufgebracht. Gleichzeitig mit dem Aufbringen der strukturierten Metallisierung 8 wird dabei ein Kontakt zwischen einem ersten Anschlußende 12 derselben und einer in der oberen Oberfläche des Schaltungschips 6 angeordneten Anschlußfläche (nicht gezeigt) hergestellt. Das zweite Anschlußende 14 der strukturierten Metallisierung 8 ist über dem Durchgangsloch 102 angeordnet. Anschließend wird der zweite Hilfsträger 104 entfernt, woraufhin durch das Durchgangsloch 102 eine Durchkontaktierung 16 zwischen der Vorderseite und der Rückseite des Transpondermoduls bewirkt wird. Eine solche Durchkontaktierung kann beispielsweise mittels einer Thermokompression oder einer Ultraschallkompression realisiert werden. Es ist für Fachleute jedoch offensichtlich, daß das Durchgangsloch 102 bereits vor dem Aufbringen der strukturierten Metallisierung 8 mit einem leitfähigen Material gefüllt werden kann, um die Durchkontaktierung 16 zu implementieren.

Nach dem Entfernen des ersten Hilfsträgers 100 ergibt sich die in Fig. 5d) gezeigte Struktur, die dem in Fig. 1 dargestellten Ausführungsbeispiel entspricht. Die Draufsicht der sich ergebenden Struktur, die der in Fig. 2 dargestellten Struktur entspricht, ist zur Komplettierung in Fig. 5e) nochmals dargestellt.

Bei dem oben beschriebenen Verfahren mit zwei sich gegenüberliegenden Metallisierungsschichten 4 und 8 ist es notwendig, daß zumindest eine der beiden Schichten strukturiert ist, d.h., daß Leiterbahnen und Kontaktflächen in derselben ausgebildet werden. Es ist für Fachleute offensichtlich, daß bei dem in Fig. 5a) gezeigten Verfahrensschritt zunächst eine strukturierte Metallisierung, die eine Spule mit den entsprechenden Anschlußenden definiert, auf den ersten Hilfsträger 100 aufgebracht werden kann. Danach kann dann in dem in Fig. 5c) dargestelltem Verfahrensstadium eine nicht strukturierte Metallisierungsschicht auf die Oberfläche des Isolationssubstrats aufgebracht werden. Auch bei dieser Vorgehensweise wird ein zu dem in Fig. 5d) dargestellten Transpondermodul im wesentlichen identisches Transpondermodul erhalten.

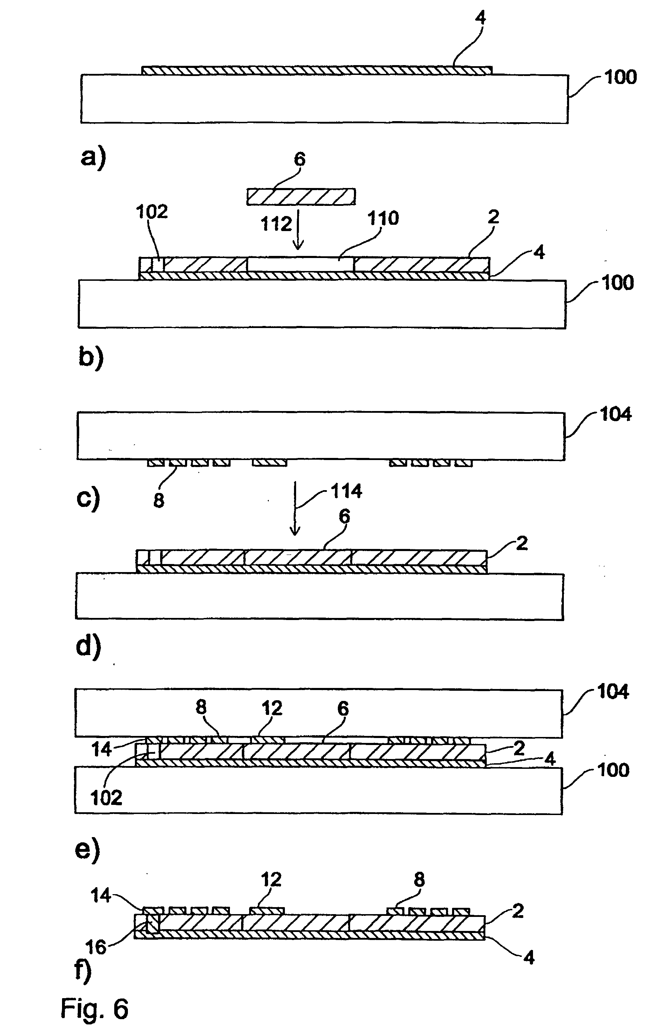

In Fig. 6 ist ein alternatives Ausführungsbeispiel eines erfindungsgemäßen Verfahrens dargestellt, mit dem ebenfalls ein Transpondermodul, wie es in Fig. 1 gezeigt ist, erhalten wird. Wie in Fig. 6a) gezeigt ist, wird wiederum zunächst eine Metallisierungsschicht 4 auf einen ersten Hilfsträger aufgebracht. Wie in Fig. 6b) gezeigt ist, wird nun auf der Metallisierungsschicht 4 das Isolationssubstrat 2 mit darin gebildeten Ausnehmungen 110 und 102 erzeugt. Die Ausnehmung 110 dient zur Aufnahme des Schaltungschips 6, der nachfolgend in die Ausnehmung eingebracht wird, wie durch den Pfeil 112 in Fig. 6b) gezeigt ist. Die Ausnehmung 102 dient wiederum zur Herstellung einer Durchkontaktierung. Es ist offensichtlich, daß die Ausnehmungen 110 und 102 in dem Isolationssubstrat 2 beispielsweise mittels herkömmlicher lithographischer Techniken gebildet werden können. Anderenfalls kann eine bereits mit den Ausnehmungen versehene Isolationsschicht auf die Metallisierungsschicht 4 aufgebracht werden.

Die Verfahren zur Herstellung der Durchkontaktierungsöffnung 102 sowie gegebenenfalls gleichzeitiger Ausnehmung 110 für den Schaltungschip sollten möglichst schnell und preiswert sein. Beispielsweise kann eine Durchkontaktierung erzeugt werden, indem ein Loch in die Isolationsschicht gebohrt wird und ein Draht durch die Öffnung 102 auf die Metallisierungsebene 4 hier geführt wird. Das Bohren kann dabei mechanisch, durch eine Laserbestrahlung, durch eine Ultraschallbestrahlung oder auch durch ein chemisches Naß- oder Trocken-Ätzen erfolgen. Bei der chemischen Locherzeugung kann auf ein Lithographieverfahren verzichtet werden, wenn das Aufbringen der ätzenden Substanz lokal begrenzt werden kann, beispielsweise durch eine Kanüle mit Absaugung der Reststoffe. Gleichzeitig mit dem Bilden des Durchgangslochs 102 wird vorzugsweise die Ausnehmung 110 in der Isolationsschicht für den Schaltungschip hergestellt, wobei sinnvollerweise die gleichen Verfahren wie für die Bildung des Durchgangslochs 102 verwendet werden.

Nach dem Einbringen des Schaltungschips 6 entspricht die Struktur bei dem Verfahren gemäß Fig. 6 der Struktur, die in Fig. 5b) gezeigt ist. Die weiteren Verfahrensschritte entsprechen somit denen des bezugnehmend auf die Fig. 5a) bis 5e) beschriebenen Ausführungsbeispiels, wobei in Fig. 6c) die auf den zweiten Hilfsträger 104 aufgebrachte strukturierte Metallisierung 8 gezeigt ist, die auf das Isolationssubstrat 2 und den Schaltungschip 6 aufgebracht wird, wie durch einen Pfeil 114 dargestellt ist. Die Fig. 6d) bis 6f) entsprechen den Fig. 5b) bis 5d).

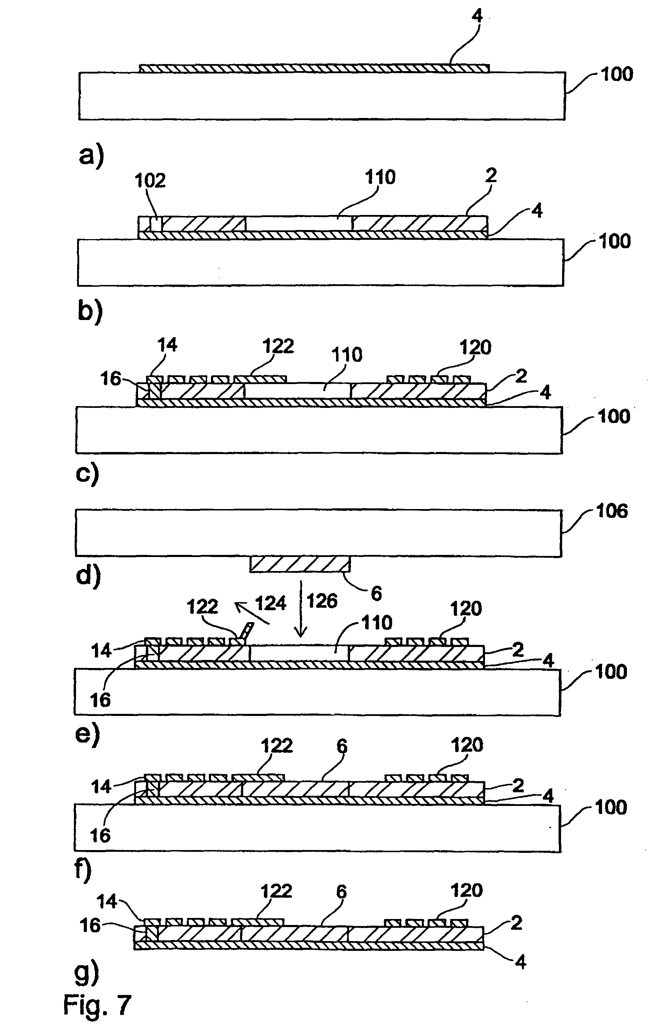

Ein drittes Ausführungsbeispiel des erfindungsgemäßen Verfahrens wird nun bezugnehmend auf Fig. 7 beschrieben. Dabei entsprechen die in Fig. 7a) und 7b) gezeigten Verfahrensschritte dem gemäß den Fig. 6a) und 6b) beschriebenen Verfahren vor dem Einbringen des Schaltungschips 6.

Wie nun in Fig. 7c) gezeigt ist, wird nachfolgend eine strukturierte Metallisierungsschicht 120 auf die obere Oberfläche des Isolationssubstrats 2 aufgebracht, wobei ein erstes Anschlußende 122 der strukturierten Metallisierung 120 die Ausnehmung 110 überlappt. Bei der Darstellung von Fig. 7c) ist die Durchkontaktierung 16 durch das Isolationssubstrat 2 bereits erfolgt. Es ist jedoch offensichtlich, daß, wie oben erläutert, die Durchkontaktierung auch erst in einem späteren Verfahrensstadium durchgeführt werden könnte. Die Metallisierungsschicht 120 kann wiederum mittels eines zweiten Hilfsträgers aufgebracht werden oder wird alternativ aus einer flächig aufgebrachten Metallschicht strukturiert. Beispielsweise kann eine Metallisierungsschicht ganzflächig durch galvanische Abscheidung auf dem Substrat erzeugt und anschließend strukturiert werden. Wird jedoch eine strukturierte Metallisierung mittels eines Hilfsträgers aufgebracht, wird der Hilfsträger unmittelbar nachfolgend beseitigt.

Nun wird, wie in Fig. 7d) gezeigt ist, der Schaltungschip 6 herangeführt, der an einem dritten Hilfsträger 106 angebracht sein kann. Bevor der Schaltungschip 6 jedoch in die Ausnehmung 110 eingebracht werden kann, muß das überlappende Ende 122 mechanisch aufgebogen werden, wie durch einen Pfeil 124 in Fig. (7e) gezeigt ist. Dadurch wird die Aussparung 110 vollständig geöffnet, so daß der Schaltungschip 6 in derselben plaziert (Pfeil 126) und gleichzeitig eine leitfähige Verbindung zwischen einer in der Unterseite desselben vorgesehenen Anschlußfläche (nicht gezeigt) und der Metallisierungsschicht 4 hergestellt werden kann. Diese Kontaktierung kann mittels bekannter Verfahren, beispielsweise eines Lötens oder eines Klebens mittels eines anisotrop leitfähigen Klebers durchgeführt werden.

Nach dem Einbringen des Schaltungschips 6 in die Ausnehmung 110 wird das Anschlußende 122 der strukturierten Metallisierung 120 zurückgebogen und gleichzeitig mit einer in der oberen Oberfläche des Schaltungschips 6 vorgesehenen Anschlußfläche (nicht gezeigt) leitfähig verbunden, siehe Fig. 7f). Nach dem Entfernen des Hilfsträgers 100 wird das fertige Transpondermodul erhalten, das in Fig. 9g) dargestellt ist, wobei der Aufbau desselben im wesentlichen dem des in Fig. 1 dargestellten Ausführungsbeispiels entspricht, wobei lediglich das erste Anschlußende 122 der strukturierten Metallisierung 120 eine abweichende Form besitzt, die das oben beschriebenen Aufbiegen und Zurückbiegen desselben ermöglicht.

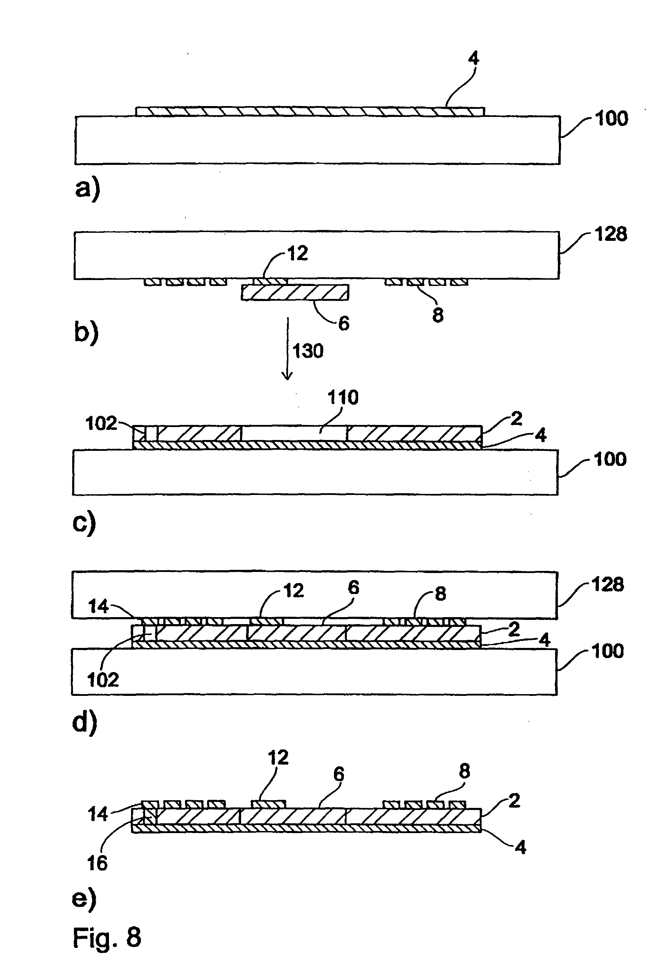

Ein letztes alternatives Ausführungsbeispiel zum Herstellen eines Transpondermoduls, bei dem der Schaltungschip Anschlußflächen in beiden Hauptoberflächen desselben aufweist, wird nachfolgend bezugnehmend auf Fig. 8 erläutert. Wiederum wird zunächst eine Metallisierungsschicht 4 auf einen ersten Hilfsträger 100 aufgebracht, siehe Fig. 8a). Auf dieser Metallisierungsschicht 4 wird in gleicher Weise wie bei dem bezugnehmend auf Fig. 6 beschriebenen Verfahren eine Isolationsschicht 2 gebildet, wie in Fig. 8c) gezeigt ist. Jedoch wird bei dem in Fig. 8 dargestellten Verfahren, der Schaltungschip 6 zunächst auf eine strukturierte Metallisierung 8, die auf einen zweiten Hilfsträger 128 aufgebracht ist, aufgebracht, derart, daß eine Anschlußfläche (nicht gezeigt) in einer ersten Hauptoberfläche desselben mit einem ersten Anschlußende 12 der strukturierten Metallisierung 8 leitfähig verbunden ist, siehe Fig. 8b). Der derart an dem Hilfsträger 128 angebrachte Chip wird dann in die Ausnehmung 110 eingebracht, siehe Pfeil 130, wobei der Hilfsträger 128 als Handhabungshilfe dient.

Die nachfolgend durchgeführten Schritte, die in Fig. 8b) und 8e) gezeigt sind, entsprechen den in den Fig. 6e) und 6f) gezeigten Schritten. Wiederum ergibt sich ein Transpondermodul, das im wesentlichen den in Fig. 1 gezeigten Aufbau aufweist.

Nach dem Fertigstellen des Transpondermoduls auf die oben beschriebene Art und Weise kann dasselbe zwischen dünne Papier- oder Kunststoffolien eingebracht werden, um somit ein einsatzfähiges elektronisches Etikett zu schaffen. Alternativ kann zu diesem Zweck ein flüssiges Isolationsmaterial verwendet werden. Wie beschrieben wurde, können zu den erfindungsgemäßen Verfahren Hilfsträger eingesetzt werden. Diese Hilfsträger können jeweils durch verschiedene lösbare Verfahren aufgebracht werden, beispielsweise mittels lösbarer Haftschichten. Alternativ kann eine Haltewirkung durch Unterdruck, elektrostatische Anziehung, Magnetismus, usw. bewirkt werden.

Bei den oben beschriebenen Verfahren wird jeweils davon ausgegangen, daß in dem Isolationssubstrat eine Ausnehmung, in die der Schaltungschip eingebracht wird, gebildet wird. Alternativ ist es bei den erfindungsgemäßen Verfahren jedoch möglich, den Schaltungschip mittels Thermokompression in ein Isolationssubstrat einzubringen, so daß derselbe nach diesem Einbringen eingepaßt in einer Ausnehmung des Isolationssubstrats angeordnet ist. Ein solches Thermokompressionsverfahren kann vorteilhaft dahingehend sein, daß die Wände des Isolationssubstrats absolut konform mit den anliegenden Wänden des Schaltungschips sind.

Die vorliegende Erfindung wurde jeweils bezugnehmend auf ein Transpondermodul erläutert, bei dem die Antennenvorrichtung durch eine Spule realisiert ist. Es ist jedoch offensichtlich, daß die vorliegende Erfindung auch mit einer anderen peripheren Beschaltung, die eine Antenneneinrichtung definiert, realisierbar ist.

Trotz der geringen Dicke der erfindungsgemäßen Transpondermodule kann eine effektive Lichtabschirmung bei bevorzugten Ausführungsbeispielen bewirkt werden, indem eine Lichtabschirmung durch eine geeignete Ausgestaltung der Anschlußflächen realisiert wird. Eine weitere Dickenreduzierung kann erreicht werden, indem die strukturierte Metallisierung durch einen Draht mit einem elliptischen oder rechteckigen Querschnitt realisiert wird, der mittels eines Thermokompressionsverfahrens unter Verwendung von Ultraschall oder Wärme teilweise oder ganz in das Isolationssubstrat versenkt wird. Alternativ kann als strukturierte Metallisierung ein gestanzter Flachdraht bzw. eine gestanzte Spule verwendet werden. Das Ätzen der erforderlichen Durchkontaktierungen kann vorzugsweise durch lokale Zuführung eines Ätzmittels, beispielsweise durch eine Kanüle erfolgen, wobei gleichzeitig die Reststoffe durch die gleiche oder eine zweite Kanüle abgesaugt werden.

Es ist für Fachleute offensichtlich, daß die jeweils erforderlichen Durchkontaktierungen durch das Isolationssubstrat auf eine Vielzahl von Arten realisiert werden können. Beispielsweise kann, wie bezugnehmend auf die Figuren jeweils beschrieben wurde, eine Durchkontaktierung realisiert werden, indem ein Durchgangsloch in dem Isolationssubstrat gebildet wird, das nachfolgend mit einer Metallisierung gefüllt wird. Alternativ können die Durchkontaktierungen mittels Thermokompressionsverfahren hergestellt werden. Überdies können die jeweils erforderlichen strukturierten Metallisierungen zum einen gebildet werden, indem zunächst eine Metallisierungsschicht ganzflächig aufgebracht wird und nachfolgend strukturiert wird. Alternativ kann eine bereits strukturierte Metallisierungsschicht mittels eines Hilfsträgers aufgebracht werden.

Die erfindungsgemäßen Verfahren können zur Herstellung einer Mehrzahl von Transpondermodulen vorteilhaft angewendet werden, wenn an Seitenflächen derselben verbundene Isolationssubstrate verwendet werden, die dann sozusagen in Bandform jeweiligen Bearbeitungsstationen zugeführt werden. Die Umrisse der einzelnen Isolationssubstrate können dabei durch Perforationen definiert sein, wobei eine Trennung der Isolationssubstrate dann entlang der Perforationen erfolgt. Alternativ können die Perforationen erst nach Fertigstellung der Transpondermodule bewirkt werden.

Die vorliegende Erfindung schafft somit ultradünne Transpondermodule, die insbesondere für den Einsatz als Wegwerfelektronik in kontaktlosen elektronischen Etiketten geeignet sind. Diesselben können vorteilhaft zwischen zwei Papierschichten bzw. dünne Polymerfolien eingelegt werden, wobei aufgrund der geringen Dicke der erfindungsgemäßen Transpondermodule eine spätere Behandlung des so erzeugten elektronischen Etiketts, beispielsweise ein Bedrucken nicht beeinträchtigt wird.

## Patentansprüche

1. Verfahren zum Herstellen eines Transpondermoduls, mit folgenden Schritten:
Aufbringen einer Metallisierungsschicht (4) auf einen ersten Hilfsträger (100);
Aufbringen eines Schaltungschips (6) mit einer ersten Anschlußfläche auf einer ersten Hauptoberfläche desselben und einer zweiten Anschlußfläche auf einer der ersten Hauptoberfläche gegenüberliegenden zweiten Hauptoberfläche desselben auf die Metallisierungsschicht (4), derart, daß die zweite Anschlußfläche leitfähig mit der Metallisierungsschicht (4) verbunden ist;
Erzeugen einer Isolationsschicht (2) auf der Metallisierungsschicht (4), derart, daß der Schaltungschip (6) von der Isolationsschicht (2) umgeben ist, und die von der Metallisierungsschicht abgewandte Oberfläche der Isolationsschicht (2) bündig mit der von der Metallisierungsschicht abgewandten ersten Oberfläche des Schaltungschips (6) ist;
Erzeugen einer strukturierten Metallisierung (8) mit einem ersten und einem zweiten Verbindungsende (12, 14), die eine Antenneneinrichtung definiert, auf der Isolationsschicht (2) und dem Schaltungschip (6), derart, daß das erste Verbindungsende (12) mit der ersten Anschlußfläche des Schaltungschips (6) verbunden ist;
Erzeugen einer Durchkontaktierung (16) durch die Isolationsschicht (2), um das zweite Verbindungsende (14) der strukturierten Metallisierung (8) mit der Metallisierungsschicht (4) leitfähig zu verbinden; und
Entfernen des ersten Hilfsträgers (100).

2. Verfahren zum Herstellen eines Transpondermoduls, mit folgenden Schritten:
Aufbringen einer Metallisierungsschicht (4) auf einen ersten Hilfsträger (100);
Erzeugen einer Isolationsschicht (2) auf der Metallisierungsschicht (4);
Einbringen eines Schaltungschips (6) mit einer ersten Anschlußfläche auf einer ersten Hauptoberfläche desselben und einer zweiten Anschlußfläche auf einer der ersten Hauptoberfläche gegenüberliegenden zweiten Hauptoberfläche desselben in eine Ausnehmung (110) der Isolationsschicht (2), die die Isolationsschicht (2) bis zu der Metallisierungsschicht (4) durchdringt, derart, daß die von der Metallisierungsschicht (4) abgewandte erste Hauptoberfläche des Schaltungschips (6) im wesentlichen bündig mit der von der Metallisierungsschicht (4) abgewandten Oberfläche der Isolationsschicht (2) ist, wobei eine leitfähige Verbindung zwischen der zweiten Anschlußfläche und der Metallisierungsschicht (4) bewirkt wird;
Erzeugen einer strukturierten Metallisierung (8) mit einem ersten und einem zweiten Verbindungsende (12, 14), die eine Antenneneinrichtung definiert, auf der Isolationsschicht (2) und dem Schaltungschip (6), derart, daß das erste Verbindungsende (12) mit der ersten Anschlußfläche des Schaltungschips (6) verbunden ist;
Erzeugen einer Durchkontaktierung (16) durch die Isolationsschicht (2), um das zweite Verbindungsende (14) der strukturierten Metallisierung (8) mit der Metallisierungsschicht (4) leitfähig zu verbinden; und
Entfernen des ersten Hilfsträgers (100).

3. Verfahren zum Herstellen eines Transpondermoduls, mit folgenden Merkmalen:
Aufbringen einer Metallisierungsschicht (4) auf einen ersten Hilfsträger (100);
Erzeugen einer Isolationsschicht (2) auf der Metallisierungsschicht (4);
Erzeugen einer strukturierten Metallisierung (120) mit einem ersten Anschlußende (122) und einem zweiten Anschlußende (14), die eine Antenneneinrichtung definiert, auf der Isolationsschicht (2), derart, daß ein Abschnitt des ersten Anschlußendes (122) der strukturierten Metallisierung die Ausnehmung (110) überlappt;
Aufbiegen des überlappenden Abschnitts des ersten Anschlußendes (122);
Einbringen eines Schaltungschips (6) mit einer ersten Anschlußfläche auf einer ersten Hauptoberfläche desselben und einer zweiten Anschlußfläche auf einer der ersten Hauptoberfläche gegenüberliegenden zweiten Hauptoberfläche desselben in eine Ausnehmung (110) in der Isolationsschicht (2), die die Isolationsschicht (2) bis zu der Metallisierungsschicht (4) durchdringt, derart, daß die von der Metallisierungsschicht (4) abgewandte erste Hauptoberfläche des Schaltungschips (6) im wesentlichen bündig mit der von der Metallisierungsschicht (4) abgewandten Oberfläche der Isolationsschicht (2) ist, wobei eine leitfähige Verbindung zwischen der zweiten Anschlußfläche und der Metallisierungsschicht (4) bewirkt wird;
Biegen des aufgebogenen Abschnitts des ersten Verbindungsendes (122) der strukturierten Metallisierungsschicht (120) auf den Schaltungschip (6), um eine leitfähige Verbindung zwischen dem ersten Anschlußende (122) und der ersten Anschlußfläche des Schaltungschips (6) zu bewirken;
Erzeugen einer Durchkontaktierung (16) durch die Isolationsschicht (2) um das zweite Verbindungsende der strukturierten Metallisierung (120) mit der Metallisierungsschicht (4) leitfähig zu verbinden; und
Entfernen des ersten Hilfsträgers (100).

4. Verfahren nach einem der Ansprüche 1 bis 3, bei dem die strukturierte Metallisierung (8; 120) unter Verwendung eines zweiten Hilfsträgers (104) auf der Isolationsschicht (2) erzeugt wird, wobei der zweite Hilfsträger (104) nachfolgend entfernt wird.

5. Verfahren zum Herstellen eines Transpondermoduls, mit folgenden Schritten:
Aufbringen einer Metallisierungsschicht (4) auf einen ersten Hilfsträger (100);
Erzeugen einer Isolationsschicht (2) auf der Metallisierungsschicht (4);
Erzeugen einer strukturierten Metallisierung (8) mit einem ersten und einem zweiten Verbindungsende (12, 14), die eine Antenneneinrichtung definiert, auf einem zweiten Hilfsträger (128);
Aufbringen eines Schaltungschips (6) mit einer ersten Anschlußfläche auf einer ersten Hauptoberfläche desselben und einer zweiten Anschlußfläche auf einer der ersten Hauptoberfläche gegenüberliegenden zweiten Hauptoberfläche desselben auf der strukturierten Metallisierung (8), derart, daß die erste Anschlußfläche mit dem ersten Verbindungsende (12) der strukturierten Metallisierung (8) verbunden ist;
Einbringen des Schaltungschips (6) in eine Ausnehmung (110) der Isolationsschicht (2), die die Isolationsschicht (2) bis zu der Metallisierungsschicht (4) durchdringt, derart, daß die von der Metallisierungsschicht (4) abgewandte erste Hauptoberfläche desselben im wesentlichen bündig mit der von der Metallisierungsschicht (4) abgewandten Oberfläche der Isolationsschicht (2) ist, daß die zweite Anschlußfläche mit der Metallisierungsschicht (4) leitfähig verbunden wird, und daß die strukturierte Metallisierung (8) auf die von der Metallisierungsschicht (4) abgewandte Oberfläche der Isolationsschicht (2) aufgebracht wird;
Entfernen des zweiten Hilfsträgers (128);
Erzeugen einer Durchkontaktierung (16) durch die Isolationsschicht (2), um das zweite Verbindungsende (14) der strukturierten Metallisierung (8) mit der Metallisierungsschicht (4) leitfähig zu verbinden; und
Entfernen des ersten Hilfsträgers.

6. Verfahren nach einem der Ansprüche 1 bis 5, bei dem die strukturierte Metallisierung (8; 120) eine spiralförmige Spule (10) als Antenneneinrichtung definiert.

7. Verfahren nach einem der Ansprüche 2, 3 oder 5, bei dem die Ausnehmung in der Isolationsschicht gebildet wird, indem der Schaltungschip mittels eines Thermokompressionsverfahrens in die Isolationsschicht eingebracht wird.

8. Verfahren nach Anspruch 2 oder 5, bei dem die Ausnehmung (110; 210) vor dem Einbringen des Schaltungschips (6; 20) in der Isolationsschicht (2; 22) erzeugt wird.

9. Transpondermodul mit folgenden Merkmalen:
einer aus einem isolierenden Material bestehenden Schicht (2), die als einziges Trägersubstrat vorgesehen ist;
einer auf einer ersten Hauptoberfläche des Trägersubstrats (2) gebildeten Antenneneinrichtung (8);
einem in einer Ausnehmung des Trägersubstrats (2) derart angeordneten ungehäusten Schaltungschips (6), daß eine erste Hauptoberfläche des Schaltungschips (6) im wesentlichen bündig zu der ersten Hauptoberfläche des Trägersubstrats (2) ist, und daß eine zweite Hauptoberfläche des Schaltungschips (6), die der ersten Hauptoberfläche gegenüberliegt, bündig zu einer zweiten Hauptoberfläche des Trägersubstrats (2), die der ersten Hauptoberfläche des Trägersubstrats (2) gegenüberliegt, ist;
elektrischen Verbindungseinrichtungen (4, 12, 14) zwischen dem Schaltungschip (6) und der Antenneneinrichtung (8),
**dadurch gekennzeichnet,**
**daß** auf der zweiten Hauptoberfläche des Trägersubstrats (2) eine Metallisierungsschicht (4) im wesentlichen ganzflächig vorgesehen ist,
**daß** der Schaltungschip (6) zumindest eine Anschlußfläche auf der ersten Hauptoberfläche desselben und zumindest eine Anschlußfläche auf der zweiten Hauptoberfläche desselben aufweist, und
**daß** ein erstes Anschlußende (12) der Antenneneinrichtung mit der ersten Anschlußfläche des Schaltungschips leitfähig verbunden ist, und daß ein zweites Anschlußende (14) der Antenneneinrichtung über eine Durchkontaktierung (16) durch das Trägersubstrat (2) und die auf der zweiten Hauptoberfläche des Trägersubstrats (2) vorgesehene Metallisierungsschicht (4) mit der zweiten Anschlußfläche des Schaltungschips leitfähig verbunden ist.

10. Transpondermodul nach Anspruch 9, bei dem die Antenneneinrichtung (8) eine Spule (10) ist, die durch eine auf der ersten Hauptoberfläche des Trägersubstrats (2) spiralförmig strukturierte Metallisierung gebildet ist.

11. Transpondermodul nach Anspruch 10, bei der die Metallisierung auf der ersten Hauptoberfläche des Trägersubstrats zumindest teilweise in das Trägersubstrat versenkt ist.

12. Transpondermodul nach einem der Ansprüche 9 bis 11, bei dem der Schaltungschip auf der ersten und/oder zweiten Hauptoberfläche desselben eine Lichtschutzschicht aus Metall oder einem Halbleitermaterial, das einen geringeren Bandabstand als Silizium aufweist, oder einem hochleitfähigen Silizid aufweist.

13. Elektronisches Etikett mit einem Transpondermodul nach einem der Ansprüche 9 bis 12, wobei das Transpondermodul ohne weitere Gehäusung desselben zwischen zwei Lagen aus Papier oder dünnen Polymerfolien angeordnet ist.

## Claims

1. A method for producing a transponder module comprising the steps of:
applying a metallization layer (4) onto a first auxiliary support (100);
applying to said metallization layer (4) a circuit chip (6) having a first connecting area on a first main surface thereof and a second connecting area on a second main surface thereof, which is opposed to said first main surface, in such a way that the second connecting area is conductively connected to said metallization layer (4);
producing an insulating layer (2) on said metallization layer (4) in such a way that the circuit chip (6) is surrounded by the insulating layer (2) and that the surface of the insulating layer (2) facing away from the metallization layer is flush with the first surface of the circuit chip (6) facing away from the metallization layer;
producing a structured metallization (8) having a first and a second connection end (12, 14) and defining an antenna means, on said insulating layer (2) and said circuit chip (6) in such a way that the first connection end (12) is connected to the first connecting area of the circuit chip (6);
producing a through-contact (16) through the insulating layer (2) so as to conductively connect the second connection end (14) of the structured metallization (8) to the metallization layer (4); and
removing the first auxiliary support (100).

2. A method for producing a transponder module comprising the following steps:
applying a metallization layer (4) onto a first auxiliary support (100);
producing an insulating layer (2) on the metallization layer (4);
introducing a circuit chip (6) having a first connecting area on a first main surface thereof and a second connecting area on a second main surface thereof, which is opposed to said first main surface, into an opening (110) of the insulating layer (2) which extends through said insulating layer (2) down to the metallization layer (4), in such a way that the first main surface of the circuit chip (6) facing away from the metallization layer (4) is substantially flush with the surface of the insulating layer (2) facing away from the metallization layer (4), a conductive connection being established between the second connecting area and the metallization layer (4);
producing a structured metallization (8) having a first and a second connection end (12, 14) and defining an antenna means, on the insulating layer (2) and on the circuit chip (6) in such a way that the first connection end (12) is connected to the first connecting area of the circuit chip (6);
producing a through-contact (16) through the insulating layer (2) so as to conductively connect the second connection end (14) of the structured metallization (8) to the metallization layer (4); and
removing the first auxiliary support (100).

3. A method of producing a transponder module comprising the following steps:
applying a metallization layer (4) onto a first auxiliary support (100);
producing an insulating layer (2) on said metallization layer (4);
producing a structured metallization (120) having a first connection end (122) and a second connection end (14) and defining an antenna means, on said insulating layer (2) in such a way that a section of the first connection end (122) of the structured metallization overlaps the opening (110);
bending up the overlapping section of the first connection end (122);
introducing a circuit chip (6) having a first connecting area on a first main surface thereof and a second connecting area on a second main surface thereof, which is opposed to said first main surface, into an opening (110) of the insulating layer (2) which extends through said insulating layer (2) down to the metallization layer (4), in such a way that the first main surface of the circuit chip (6) facing away from the metallization layer (4) is substantially flush with the surface of the insulating layer (2) facing away from the metallization layer (4), a conductive connection being established between the second connecting area and the metallization layer (4);
bending the bent-up section of the first connection end (122) of the structured metallization layer (120) onto the circuit chip (6) so as to establish a conductive connection between said first connection end (122) and the first connecting area of the circuit chip (6);
producing a through-contact (16) through the insulating layer (2) so as to conductively connect the second connection end of the structured metallization (120) to the metallization layer (4); and
removing the first auxiliary support (100).

4. A method according to one of the claims 1 to 3, wherein the structured metallization (8; 120) is produced on the insulating layer (2) making use of a second auxiliary support (104), said second auxiliary support (104) being removed subsequently.

5. A method for producing a transponder module comprising the following steps:
applying a metallization layer (4) onto a first auxiliary support (100);
producing an insulating layer (2) on the metallization layer (4);
producing on a second auxiliary support (128) a structured metallization (8) having a first and a second connection end (12, 14) and defining an antenna means;
applying to said structured metallization (8) a circuit chip (6) having a first connecting area on a first main surface thereof and a second connecting area on a second main surface thereof, which is opposed to said first main surface, in such a way that the first connecting area is connected to the first connection end (12) of the structured metallization (8);
introducing the circuit chip (6) into an opening (110) of the insulating layer (2) which extends through said insulating layer (2) down to the metallization layer (4), in such a way that the first main surface of the circuit chip (6) facing away from the metallization layer (4) is substantially flush with the surface of the insulating layer (2) facing away from the metallization layer (4), that the second connecting area is conductively connected to the metallization layer (4), and that the structured metallization (8) is applied to the surface of the insulating layer (2) facing away from the metallization layer (4);
removing the second auxiliary support (128);
producing a through-contact (16) through the insulating layer (2) so as to conductively connect the second connection end (14) of the structured metallization (8) to the metallization layer (4); and
removing the first auxiliary support.

6. A method according to one of the claims 1 to 5, wherein the structured metallization (8; 120) defines a helical coil (10) as an antenna means.

7. A method according to one of the claims 2, 3 or 5, wherein the opening in the insulating layer is formed by introducing the circuit chip into said insulating layer by means of a thermocompression method.

8. A method according to claim 2 or 5, wherein the opening (110; 210) in the insulating layer (2; 22) is produced before the circuit chip (6; 20) is introduced.

9. A transponder module comprising:
a layer (2) made of an insulating material and provided as a single support substrate;
an antenna means (8) formed on a first main surface of the support substrate (2);
an unhoused circuit chip (6) arranged in an opening of the support substrate (2) in such a way that a first main surface of said circuit chip (6) is substantially flush with the first main surface of said support substrate (2), and that a second main surface of said circuit chip (6), which is opposed to said first main surface, is flush with a second main surface of said support substrate (2) which is opposed to the first main surface of said support substrate (2);
electric connection means (4, 12, 14) between the circuit chip (6) and the antenna means (8),
**characterized in**
**that** the second main surface of the support substrate (2) has provided thereon a metallization layer (4) essentially over the full area thereof,
**that** the circuit chip (6) has at least one connecting area on the first main surface thereof and at least one connecting area on the second main surface thereof, and
**that** a first connection end (12) of the antenna means is conductively connected to the first connecting area of the circuit chip, and that a second connection end (14) of the antenna means is conductively connected to the second connecting area of the circuit chip via a through-contact (16) through the support substrate (2) and the metallization layer (4) provided on the second main surface of the support substrate (2).

10. A transponder module according to claim 9, wherein the antenna means (8) is a coil (10) formed by a metallization which is helically structured on the first main surface of the support substrate (2).

11. A transponder module according to claim 10, wherein the metallization on the first main surface of the support substrate is sunk, at least partially, into said support substrate.

12. A transponder module according to one of the claims 9 to 11, wherein the circuit chip has on the first and/or second main surface thereof a light protection layer of metal, or of a semiconductor material having a smaller energy gap than silicon, or of a highly conductive silicide.

13. An electronic label comprising a transponder module according to one of the claims 9 to 12, wherein the transponder module is arranged between two layers of paper or between thin polymer foils without having any housing of its own.

## Revendications

1. Procédé pour produire un module transpondeur, aux étapes suivantes consistant à :
appliquer une couche de métallisation (4) sur un premier support auxiliaire (100) ;
appliquer sur la couche de métallisation (4) une puce de circuit (6) avec une première face de raccordement sur une première surface principale de cette dernière et une seconde face de raccordement sur une seconde surface principale, opposée à la première surface principale, de cette dernière, de sorte que la seconde face de raccordement soit assemblée de manière conductrice avec la couche de métallisation (4) ;
générer une couche isolante (2) sur la couche de métallisation (4), de sorte que la puce de circuit (6) soit entourée par la couche isolante (2) et que la surface, éloignée de la couche de métallisation, de la couche isolante (2) se trouve à plat sur la première surface, éloignée de la couche de métallisation, de la puce de circuit (6) ;
générer une métallisation structurée (8) avec une première et une seconde extrémité de connexion (12, 14), définissant un dispositif d'antenne, sur la couche isolante (2) et la puce de circuit (6), de sorte que la première extrémité de connexion (12) soit assemblée avec la première face de raccordement de la puce de circuit (6) ;
générer une mise en contact traversante (16) dans la couche isolante (2), pour assembler de manière conductrice la seconde extrémité de connexion (14) de la métallisation structurée (8) avec la couche de métallisation (4) ; et
éliminer le premier support auxiliaire (100).

2. Procédé pour produire un module transpondeur, aux étapes suivantes consistant à :
appliquer une couche de métallisation (4) sur un premier support auxiliaire (100) ;
générer une couche isolante (2) sur la couche de métallisation (4) ;
introduire une puce de circuit (6) avec une première face de raccordement sur une première surface principale de cette dernière et une seconde face de raccordement sur une seconde surface principale, opposée à la première surface principale, de cette dernière dans un évidemment (110) de la couche isolante (2) traversant la couche isolante (2) jusqu'à la couche de métallisation (4), de sorte que la première surface principale, éloignée de la couche de métallisation, de la puce de circuit (6) se trouve sensiblement à plat sur la surface, éloignée de la couche de métallisation, de la couche isolante (2), un assemblage conducteur étant ainsi créé entre la seconde face de raccordement et la couche de métallisation (4) ;
générer une métallisation structurée (8) avec une première et une seconde extrémité de connexion (12, 14), définissant un dispositif d'antenne, sur la couche isolante (2) et la puce de circuit (6), de sorte que la première extrémité de connexion (12) soit assemblée avec la première face de raccordement de la puce de circuit (6) ;
générer une mise en contact traversante (16) dans la couche isolante (2), pour assembler de manière conductrice la seconde extrémité de connexion (14) de la métallisation structurée (8) avec la couche de métallisation (4) ; et
éliminer le premier support auxiliaire (100).

3. Procédé pour produire un module transpondeur, aux caractéristiques suivantes :
appliquer une couche de métallisation (4) sur un premier support auxiliaire (100) ;
générer une couche isolante (2) sur la couche de métallisation (4) ;
générer une métallisation structurée (120) avec une première extrémité de raccordement (122) et une seconde extrémité de raccordement (124), définissant un dispositif d'antenne, sur la couche isolante (2), de sorte qu'un segment de la première extrémité de raccordement (122) de la métallisation structurée recouvre l'évidement (110);
replier le segment recouvrant de la première extrémité de raccordement (122) ;
introduire une puce de circuit (6) avec une première face de raccordement sur une première surface principale de cette dernière et une seconde face de raccordement sur une seconde surface principale, opposée à la première surface principale, de cette dernière dans un évidement (110) dans la couche isolante (2) traversant la couche isolante (2) jusqu'à la couche de métallisation (4), de sorte que la première surface principale, éloignée de la couche de métallisation, de la puce de circuit (6) se trouve sensiblement à plat sur la surface, éloignée de la couche de métallisation (4), de la couche isolante (2), un assemblage conducteur étant ainsi créé entre la seconde face de raccordement et la couche de métallisation (4) ;
plier le segment replié de la première extrémité de raccordement (122) de la couche de métallisation structurée (120) sur la puce de circuit (6), pour créer un assemblage conducteur entre la première extrémité de raccordement (122) et la première face de raccordement de la puce de circuit (6) ;
générer une mise en contact traversante (16) dans la couche isolante (2), pour assembler de manière conductrice la seconde extrémité de connexion de la métallisation structurée (120) avec la couche de métallisation (4) ; et
éliminer le premier support auxiliaire (100).

4. Procédé selon l'une des revendications 1 à 3, dans lequel la métallisation structurée (8 ; 120) est générée, à l'aide d'un second support auxiliaire (104), sur la couche isolante (2), le second support auxiliaire (104) étant ensuite éliminé.

5. Procédé pour produire un module transpondeur, aux étapes suivantes consistant à :
appliquer une couche de métallisation (4) sur un premier support auxiliaire (100) ;
générer une couche isolante (2) sur la couche de métallisation (4) ;
générer une métallisation structurée (8) avec une première et une seconde extrémité de connexion (12, 14), définissant un dispositif d'antenne, sur un second support auxiliaire (128);
appliquer sur la métallisation structurée (8) une puce de circuit (6) avec une première face de raccordement sur une première surface principale de cette dernière et une seconde face de raccordement sur une seconde surface principale, opposée à la première surface principale, de cette dernière, de sorte que la première face de raccordement soit assemblée avec la première extrémité de connexion (12) de la métallisation structurée (8) ;
introduire la puce de circuit (6) dans un évidemment (110) de la couche isolante (2) traversant la couche isolante (2) jusqu'à la couche de métallisation (4), de sorte que la première surface principale, éloignée de la couche de métallisation (4), de cette dernière se trouve sensiblement à plat sur la surface, éloignée de la couche de métallisation (4), de la couche isolante (2), que la seconde face de raccordement soit assemblée de manière conductrice avec la couche de métallisation (4) et que la métallisation structurée (8) soit appliquée sur la surface, éloignée de la couche de métallisation (4), de la couche isolante (2) ;
éliminer le second support auxiliaire (128) ;
générer une mise en contact traversante (16) dans la couche isolante (2), pour assembler de manière conductrice la seconde extrémité de connexion (14) de la métallisation structurée (8) avec la couche de métallisation (4) ; et
éliminer le premier support auxiliaire.

6. Procédé selon l'une des revendications 1 à 5, dans lequel la métallisation structurée (8 ; 120) définit une bobine hélicoïdale (10) comme dispositif d'antenne.

7. Procédé selon l'une des revendications 2, 3 ou 5, dans lequel l'évidement est formé dans la couche isolante en introduisant la puce de circuit dans la couche isolante à l'aide d'un procédé de thermocompression.

8. Procédé selon la revendication 2 ou 5, dans lequel l'évidemment (110 ; 210) est généré avec l'introduction de la puce de circuit (6 : 20) dans la couche isolante (2 ; 22).

9. Module transpondeur, aux caractéristiques suivantes :
une couche (2) d'un matériau isolant, prévue comme substrat de support unique ;
un dispositif d'antenne (8) formé sur une première surface principale du substrat de support (2) ;
une puce de circuit (6) sans boîtier disposée dans un évidement du substrat de support (2), de telle sorte qu'une première surface principale de la puce de circuit (6) se trouve sensiblement à plat sur la première surface principale du substrat de support (2) et qu'une seconde surface principale de la puce de circuit (6), opposée à la première surface principale, se trouve à plat sur une seconde surface principale du substrat de support (2) opposée à la première surface principale du substrat de support (2) ;
aménagements de connexion électrique (4, 12, 14) entre la puce de circuit (6) et le dispositif d'antenne (8),
**caractérisé par le fait**
**que** sur la seconde surface principale du substrat de support (2) est prévue, sensiblement sur toute la surface, une couche de métallisation (4),
**que** la puce de circuit (6) présente au moins une face de raccordement sur la première surface principale de celle-ci et au moins une face de raccordement sur la seconde surface principale de celle-ci, et
**qu'**une première extrémité de raccordement (12) du dispositif d'antenne est assemblée de manière conductrice avec la première face de raccordement de la puce de circuit et qu'une seconde extrémité de raccordement (14) du dispositif d'antenne est assemblée de manière conductrice, par l'intermédiaire d'une mise en contact traversante (16) dans le substrat de support (2) et la couche de métallisation (4) prévue sur la seconde surface principale du substrat de support (2), avec la seconde face de raccordement de la puce de circuit.

10. Module transpondeur selon la revendication 9, dans lequel le dispositif d'antenne (8) est une bobine (10) formée par une métallisation structurée en spirale sur la première surface principale du substrat de support (2).

11. Module transpondeur selon la revendication 10, dans lequel la métallisation sur la première surface principale du substrat de support est noyée du moins partiellement dans le substrat de support.

12. Module transpondeur selon l'une des revendications 9 à 11, dans lequel la puce de circuit présente sur sa première et/ou la seconde surface principale une couche de protection contre la lumière réalisée en métal ou en un matériau semi-conducteur présentant un plus petit intervalle de bande que le silicium, ou en un siliciure hautement conducteur.

13. Etiquette électronique avec un module transpondeur selon l'une des revendications 9 à 12, le module transpondeur étant disposé, sans autre mise sous boîtier de celui-ci, entre deux couches de papier ou de minces films polymères.
